# EUROPEAN PATENT APPLICATION

(11) **EP 1 739 705 A2**
(43) Date of publication of application: **03.01.2007**
(21) Application number: 05016088.6
(22) Date of filing: 25.07.2005
(51) Int. Cl.: H01J 1/304, H01J 9/02

(54) **Continuously cleaning of the emission surface of a cold field emission gun using UV or laser beams**

(30) Priority: 30.06.2005 EP 05014185
(71) Applicant: ICT, Integrated Circuit Testing Gesellschaft für Halbleiterprüftechnik Mbh, 85551 Heimstetten (DE)
(72) Inventor: Zhou, Fang, 85652 Pliening/Landsham (DE); Adamec, Pavel, 85540 Haar (DE)
(74) Representative: Zimmermann, Gerd Heinrich

(57) **Abstract**

A field emitter arrangement (100, 200, 300, 400, 500, 600) is provided, said field emitter arrangement (100, 200, 300, 400, 500, 600) comprising: a field emitter tip (10) having an emitting surface (11), and at least one light source (20) adapted to illuminate the emitting surface (11) of the field emitter tip (10). Furthermore, a method of cleaning an emitting surface of a field emitter tip is provided, the method comprising the steps of: providing a field emitter tip having an emitting surface and a light source (1000) and illuminating the emitting surface of the field emitter tip with the light source (1100).

## Description

### FIELD OF THE INVENTION

The invention relates to a field emitter arrangement as well as to a method of cleaning an emitting surface of a field emitter tip.

### BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focused in electron beam devices like electron microscopes or electron beam pattern generators. Electrons beams offer superior spatial resolution compared to e.g. photon beams due to their short wave lengths at a comparable particle energy.

The first step in the process of creating images in any electron microscope is the production of an electron beam. The electron beam is generated in a device often called an electron gun. Three major types of electron guns are used in electron microscopes: tungsten-hairpin filament guns, lanthanum-hexaboride guns, and field-emission guns. Field-emission guns offer several advantages over tungsten-hairpin filament guns or lanthanum-hexaboride guns: First, the brightness may be up to a thousand times greater than that of a tungsten gun. Second, the electrons are emitted from a point more narrow than that in the other sources. Thus, superior resolution is achieved by field-emission guns compared to tungsten or LaB₆ guns. Furthermore, the energy spread of the emitted electrons is only about one-tenth that of the tungsten-hairpin gun and one-fifth that of the LaB₆ gun. Finally, the field-emission gun has a very long life, up to a hundred times that of a tungsten gun. For these reasons, the field-emission gun is the preferred choice for a number of applications.

There exist three major types of field emission guns: cold field emission guns, thermal field emission guns and Schottky emitters. While cold field emission guns rely on the pure field emission effect, thermal field emission guns enhance the pure field emission effect by giving some thermal energy to the electrons in the metal, so that the required tunneling distance is shorter for successful escape from the surface. A Schottky emitter is a thermal field emitter that has been further enhanced by doping the surface of the emitter to reduce the work function.

The cold field emitter tip has the highest brightness of presently known emitters and is therefore the preferred choice for obtaining highest possible electron density in the smallest spot. Thus, electron microscopes equipped with cold cathode emitters are superbly suited to obtain high resolution, high quality images - especially at very low acceleration voltages. Due to their high brightness and excellent coherence, cold field emitters are predestined for use in transmission electron microscopes (TEMs). Extra advantages of cold emitters are their long lifetime and ease of use, which reduces the cost of ownership.

However, during operation continual adsorption and occasional desorption of residual gas molecules occurs on the emitting surface of cold field electron emitters. These adsorptions and desorptions lead to continuously degraded and momentarily instable emission current, respectively, so that the emitting surface has to be cleaned in regular intervals. Conventionally, this is done by a so-called "flashing" method. According to the flashing method, a heating current is supplied to the emitter so that the emitting surface heats up and the debris is removed from the surface. Heating the tip momentarily (flashing) can clean it, but new atoms and molecules quickly readsorb even in the best of vacuums. In addition, atoms may be ionized by the electron beam and subsequently accelerated back into the tip, causing physical sputtering of the tip itself. To minimize the current fluctuations, the electron source must be operated in an extreme ultra high vacuum environment, 10⁻¹⁰ Torr or better. Another disadvantage of the flashing procedure is due to the fact that the whole tip is heated during flashing. Therefore, the tip does not maintain its desired shape but alters its radius, i.e. the emitter tip becomes sharper or wider. This, in turn, affects the emission properties of the emitter tip and results in undesired variations of the emission characteristics of the emitter tip.

Further to this, the use of the electron microscope has to be suspended during the flashing process which may take some minutes or even longer. This reduces the effective working time of the microscope and is especially undesirable in high through-put applications like wafer inspection or the like.

It is therefore an object of the present invention to overcome at least partially the disadvantages associated with the prior art as they have been explained above.

### SUMMARY OF THE INVENTION

This object is solved by a field emitter arrangement according to claim 1, a charged particle apparatus according to claim 12 and cleaning method according to claim 13.

Further advantages, features, aspects and details of the invention are evident from the dependent claims, the description and the accompanying drawings.

According to a first aspect of the present invention a field emission gun arrangement is provided which comprises a field emitter with an emitting surface, and a photon source adjusted to illuminate the emitting surface of the field emitter.

Photons can desorb gas molecules from metal surfaces, particularly in vacuum. Therefore, the emitting surface of the emitter tip may be kept continuously clean by illuminating it with light. Furthermore, the incident light does not change the properties of the electron optics system so that it does not interfere with the operation of the charged particle beam apparatus. Thus, the emitting surface of the emitter tip can be continuously kept clean so that a stable electron beam is emitted. Furthermore, the operation of the charged particle beam apparatus has not to be suspended during the cleaning.

According to an embodiment of the present invention, the photon source is a laser. When the photon or light source is realized as a laser, it provides a light of high intensity and low divergence. Accordingly, no complicated optical means is required for focusing the light beam onto the emitter surface.

According to another embodiment of the present invention, the light source is a source of UV light, e.g. a UV laser. UV light has a higher energy and will directly excite the adsorbed atoms and/or molecules. Thus, UV light induces strong gas desorption while not heating the emitting surface. Therefore, UV light is also called "cold light". Since the UV does not heat the emitter tip or only the emitting surface but not the bulk of the tip, no variation of the geometric shape of the tip occurs and the emission characteristics can be maintained.

Typically, the illumination with UV light will generate few photo electrons emitted from the emitter tip. However, these photo electrons will have initial energies larger than 1 eV so that they can be easily separated from the low energy electrons generated by field emission. For this purpose, the field emission gun arrangement may further comprise an energy filter for removing photo-emitted electrons from the electron beam generated by the field emitter.

According to another embodiment of the present invention, the light source is adapted for pulsed illumination of the emitting surface. Thus, in cases where the emission of photo electrons is very high or if the emitted photo electrons have an energy similar to the energy of the field-emitted electrons or if the light source emits high optical power, excess production of photo electrons, particularly within an energy range similar to the field-emitted electrons, or excess heating of the emitter can be prevented due to the pulsed operation of the light source.

According to another embodiment of the present invention, the field emission gun arrangement comprises further synchronization means. These synchronization means are adapted to synchronize the pulse duration and the intervals between subsequent light pulses with a blanking means for blanking the electron beam, e.g. during line blanking or frame blanking. Thus, the emitting surface is illuminated only when the electron beam is blanked, i.e. during times when the electron beam does not contribute to the imaging process.

According to even another embodiment of the present invention, the light source is adapted so that the optical power radiated by the light source onto the emitting surface does not raise the temperature of the emitter tip above 1500°K. Thus, strong thermal emission, which is dangerous for the field emitter gun, is avoided. Typically, only the emitting surface is heated by the illumination but not the bulk of the emitter tip.

According to even a further embodiment of the present invention, the light source simultaneously illuminates several emitter tips in a field emitter array. Thus, several emitter tips can be cleaned by only one light source.

According to another aspect of the present invention, a method of cleansing the emitting surface of a field emitter tip is provided, wherein the method comprises the steps of: providing a field emitter tip having an emitting surface and a light source and illuminating the emitting surface of the field emitter tip with the light source. Thus, a cleansing method is provided which does not require suspension of the operation of the emitter. According to further embodiments of the present invention, the emitter tip can be continuously illuminated by the light source or in a pulsed manner. Furthermore, the above described method can be combined with conventional flashing to prolong the intervals between subsequent conventional flashing processes. Thus, the efficiency of the charged particle beam apparatus is improved.

### BRIEF DESCRIPTION OF THE DRAWINGS

Some of the above indicated and other more detailed aspects of the invention will be described in the following description and partially illustrated with reference to the figures. Therein:
- Fig. 1: shows an emitter arrangement according to an embodiment of the present invention.

- Fig. 2: shows an emitter arrangement according to another embodiment of the present invention.
- Fig. 3: shows an emitter arrangement according to a further embodiment of the present invention.
- Fig. 4: shows the emitter arrangement of Fig. 3 with a pulsed operation of the light source.
- Fig. 5: shows a blank control synchronization according to an embodiment of the present invention.
- Fig. 6: shows an emitter arrangement according to still a further embodiment of the present invention.
- Fig. 7: shows a charged particle apparatus equipped with an emitter arrangement according to an embodiment of the present invention.
- Figs. 8A and 8B: show flowcharts of cleaning methods according to embodiments of the present invention.

### DETAILED DESCRIPTION OF THE DRAWINGS

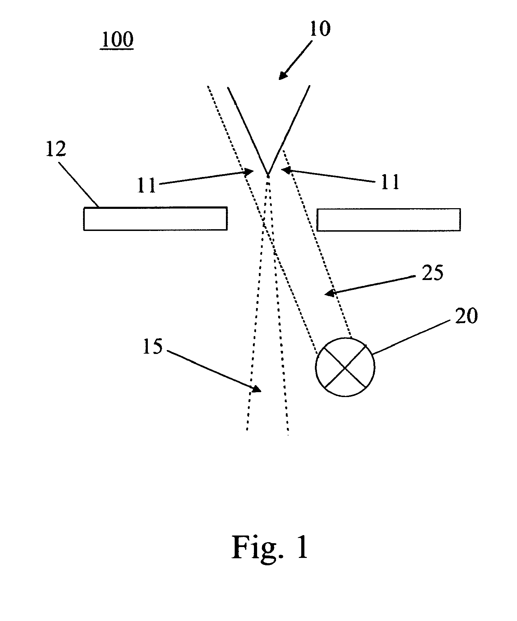

Fig. 1 shows an emitter arrangement 100 according to an embodiment of the present invention. Therein, an emitter tip 10 of a field emission gun is provided. The emitter tip comprises an emitting surface 11 from which the charged particles, i.e. electrons in the present embodiment, are emitted. Furthermore, an extraction electrode 12 is arranged near the tip of the emitter. A voltage difference can be applied between the extraction electrode 12 and the emitter tip 10. Due to the sharply pointed shape of the emitter tip, very high field strengths build up at the pointed tip end of the emitter. The field strength is high enough to continuously extract electrons from the emitter tip 10 so that they form an electron beam 15. For example, electron beam 15 is used in wafer inspection or electron beam lithography processes.

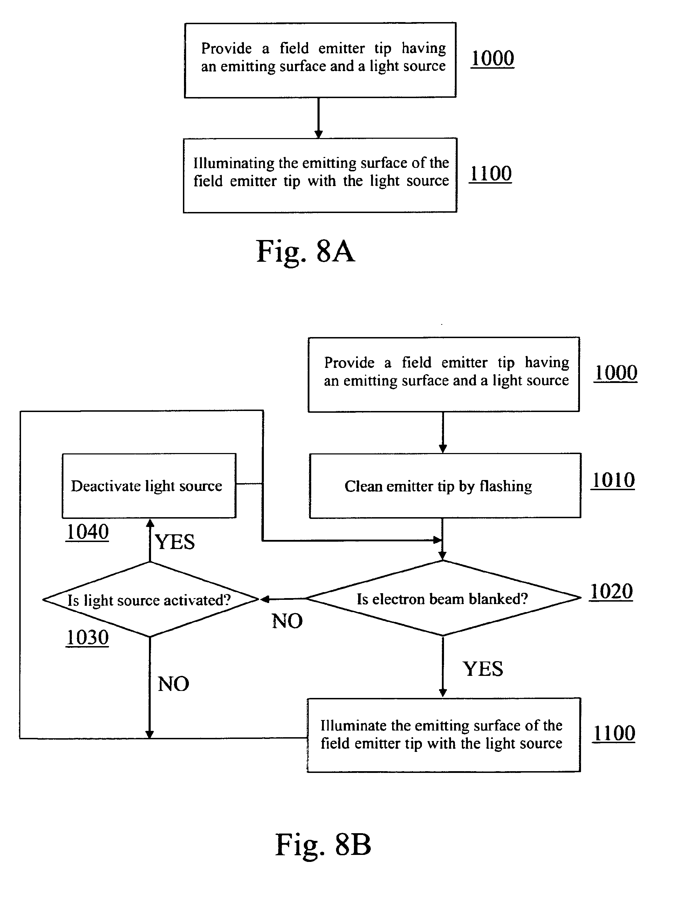

According to the embodiment of the present invention shown in Fig. 1, there is further provided a light source 20. Light source 20 is adapted to illuminate the emitting surface 11 of the emitter tip 10 with light beam 25. Providing the emitter tip 10 and light source 20 is the first step 1000 of a cleansing method according to an embodiment of the present invention. A flowchart of this cleaning method is shown in Fig. 8A.

Since photons can be used to desorb atoms and/or molecules adsorbed at the emitting surface 11, the illumination of the emitting surface 11 with photons generated by light source 20 causes desorption of the adsorbed atoms and/or molecules. Thus, in a second step 1100 of the cleansing method, the emitting surface is cleansed by the illumination and stable emission of the electron beam is provided. Furthermore, the light source may be continuously operated so that the operation of the charged particle beam apparatus has not to be suspended for the cleansing operation.

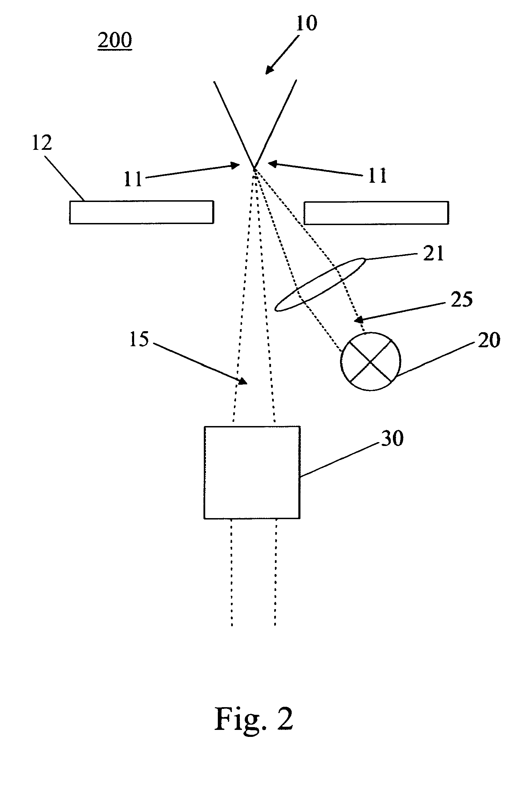

Fig. 2 shows an emitter arrangement 200 according to another embodiment of the present invention. Therein, a lens 21 is provided for focusing light beam 25 generated by light source 20 onto the emitting surface 11. Thus, the light intensity at the emitting surface is improved. Typically, the light source 20 is a source of UV light since the high energy of UV photons is especially effective for desorption of the adhering atoms and/or molecules since the UV light will directly excite the desorbed atoms and/or molecules but not heat the emitter tip 10. In this case, however, photo emission of electrons from the emitter tip 10 is stimulated by the UV light 25. The photo emitted electrons will also be accelerated by extraction electrodes 12 and are contained within the electron beam 15. Typically, the photo electrons have a much larger energy than the field-emitted electrons. Therefore, they can be easily removed from electron beam 15 by an energy filter 30, e.g. a Wien filter.

Although a lens 21 is shown in Fig. 2, the optical means may also comprise one or more mirrors (not shown). The light from the light source 20 will then be directed onto the emitting surface 11 of the emitter tip 10 by the mirrors. Such a mirror system may be also used in cases where the light source 20 is a laser.

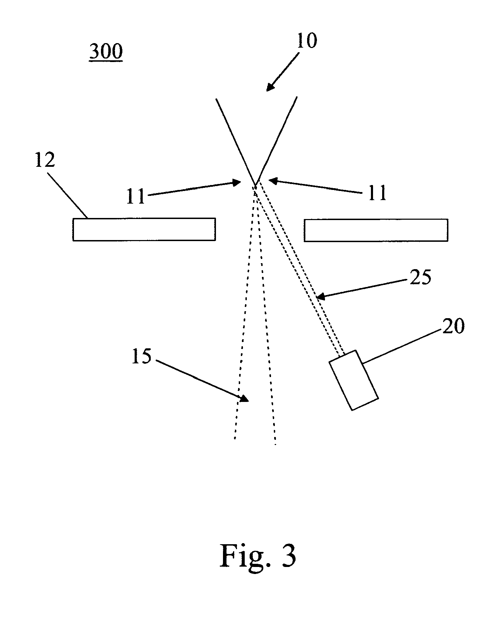

Fig. 3 shows an emitter arrangement 300 according to a further embodiment of the present invention. Therein, the light source 20 is a laser. Any type of laser, even UV lasers, may be used as long as it is appropriate for desorbing the atoms and/or molecules at the emitting surface 11. The use of lasers has certain advantages like the high intensity and the low divergence of their beams. Therefore, the use of a laser as the light source may render optical means like lenses dispensable so that they can be omitted.

In the embodiment shown in Fig. 3, the laser beam illuminates the emitting surface continuously. However, since laser light has a high intensity it may heat up the emitter tip 10. Such heating of the emitter tip 10 may only be tolerable within certain boundaries. For example, it is typically not acceptable for a cold field emitter to be heated to temperatures above 1500°K since then the thermal emission from the emitter tip interferes strongly with the field emission.

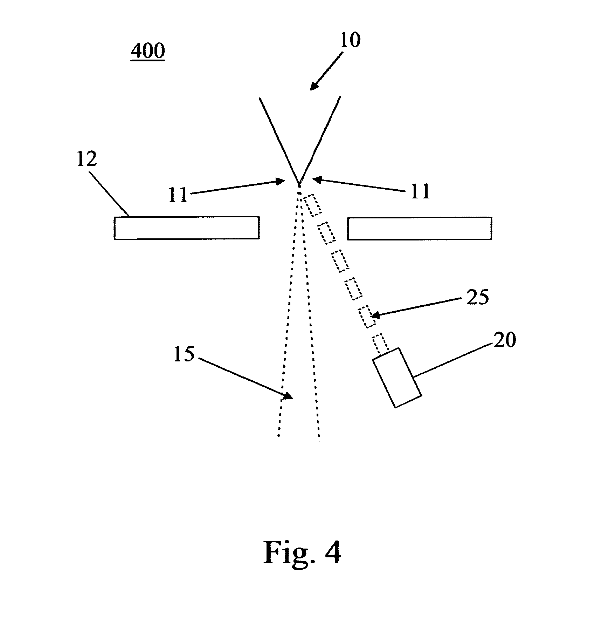

However, excessive heating of the emitter tip can be avoided by the embodiment shown in Fig. 4. Therein, the emitter arrangement 400 is similar to the embodiment shown in Fig. 3 but the laser is operated in a pulsed manner, i.e. discontinuously. Thus, the total optical power emitted by the laser 20 is reduced compared to the continuous operation and excessive heating of the emitter tip can be prevented. Typically, only the emitting surface will be heated for a short period but not the bulk of the emitter tip.

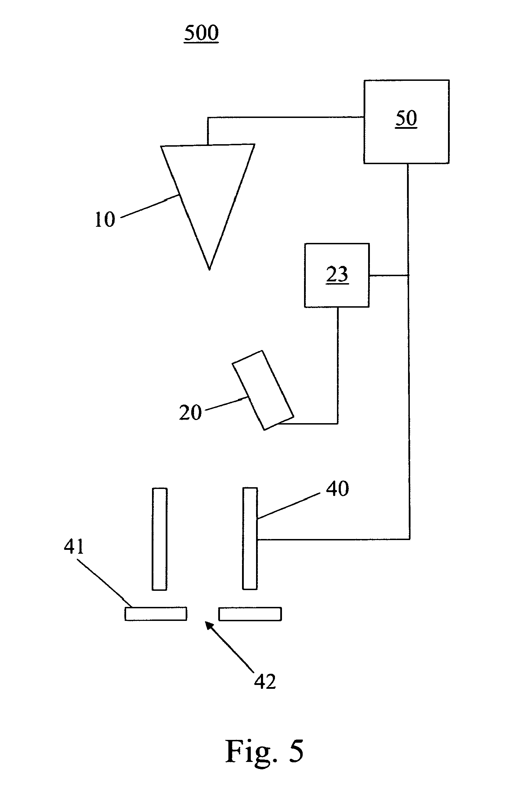

A further advantage of pulsed operation of the light source can be realized with a blank control synchronization shown in Fig. 5 and a corresponding cleansing method illustrated in Fig. 8B. Therein, blanking means 40 for line blanking or frame blanking of the electron beam are provided in a further embodiment of a field emitter arrangement 500. Typically, the blanking means 40 are realized as electrodes for deflecting the electron beam away from an opening 42 of aperture means 41. The blanking means 40 is connected to a blanking control 50 which controls the blanking means 40. Furthermore, synchronization means 23 for synchronizing the light pulses of the light source 20 with the blanking means 40 are provided. Thus, the light pulses can be synchronized with line blanking or frame blanking so that the emitting surface 11 is illuminated only when the electron beam 15 is blanked, i.e. during periods when the electron beam does not contribute to the imaging process. According to Fig. 5, the blanking means 40 are realized as electrodes and aperture means. However, blanking may also be achieved by other means, e.g. by controlling the extraction voltage of the electron gun so that the extraction voltage is reduced and only very few electrons are extracted.

In the cleansing method illustrated in Fig. 8B, it is shown that in a first cleansing step prior to operation of the device, the emitter tip 10 is cleansed by conventional flashing (step 1010). Then, operation of the device is started and the synchronization means 23 checks in step 1020 whether blanking means 40 blanks the electron beam 15. If synchronization means 23 detects that blanking means 40 blanks the electron beam 15, it will drive light source 20 to illuminate the emitting surface of the emitter tip. The synchronization means 23 returns to step 1020 so that, as long as electron beam 15 is blanked, the emitting surface is illuminated by light source 20 and, thus, cleansed. As soon as electron beam 15 is not longer blanked by blanking means 40, synchronizing means 23 detects that the electron beam is not longer blanked and detects in step 1030 whether the light source is still activated. If light source 20 is still activated, it will be deactivated in step 1040 and synchronization means 23 returns to step 1020. Accordingly, a cleansing method is provided which illuminates the emitting surface 11 of the emitter tip 10 only during blanking periods of the electron beam 15. It should be understood that further steps may be added to the above described method, for example a step of controlling the total amount of optical power transferred to the emitting surface to control the temperature thereof or a step of removing photo-emitted electrons from the electron beam 15. Furthermore, it should be understood that, when light source 20 is a pulsed light source, the pulse duration as well as the duration of the intervals between two successive pulses may be selected to be identical to the duration of blanking and the duration of a write/read interval, respectively. Thus, synchronization between the pulsed light source and the blanking may also be achieved.

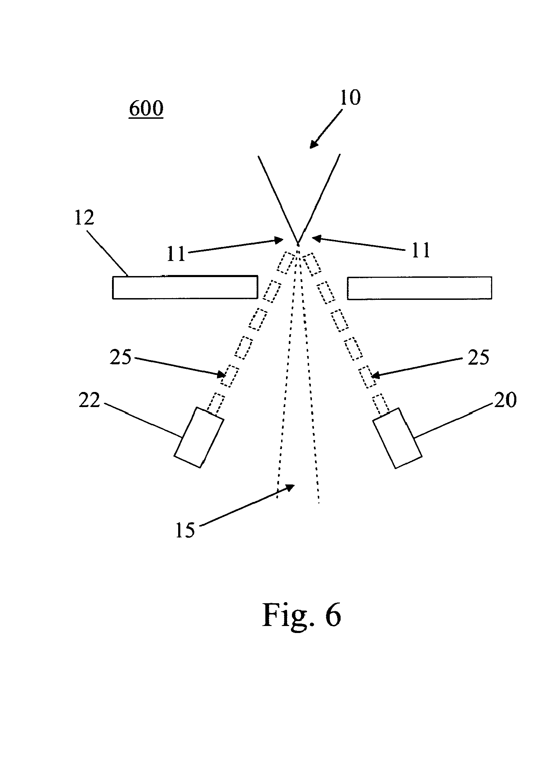

Fig. 6 shows an emitter arrangement 600 according to still a further embodiment of the present invention. Therein, a further light source 22 is provided opposite to the first light source 20. Also the second light source 22 is realized as a pulsed laser but could also be one of the other above mentioned light sources, e.g. a UV light source. Due to the second light source 22 opposite to the first light source 20, the illumination uniformity of the emitting surface 11 is improved since dark areas are reduced. In the embodiment shown in Fig. 6, the pulses of the first and second lasers 20, 22 are synchronized so that the pulses from the first and second lasers arrive simultaneously at the emitting surface. However, the pulses may also have a certain phase difference, e.g. 180°, or may be even unsynchronized. Furthermore, the pulse duration and intervals may be different for the first and second lasers 20, 22.

As an alternative embodiment, the second light source 22 may be omitted. Instead, the light from the first source 20 is split into two or more beams and directed onto the emitting surface from different positions. For this purpose, a mirror arrangement is provided. Such a mirror arrangement comprises a beam splitter and several mirrors for redirecting the beams from the beam splitter. For example, the light source 20 is a laser and the laser beam enters a beam splitter where it is split into two beams. By means of a mirror arrangement, one of the beams emerging from the beam splitter is directed onto the emitting surface from a position of the first light source 20 in Fig. 6 and the second beam is directed onto the emitting surface from a position of the second light source 22 in Fig. 6. Thus, opposite sides of the emitting surface can illuminated simultaneously with only a single light source. Of course, the beam could be split into further sub-beams which may be directed on the emitting surface from further positions.

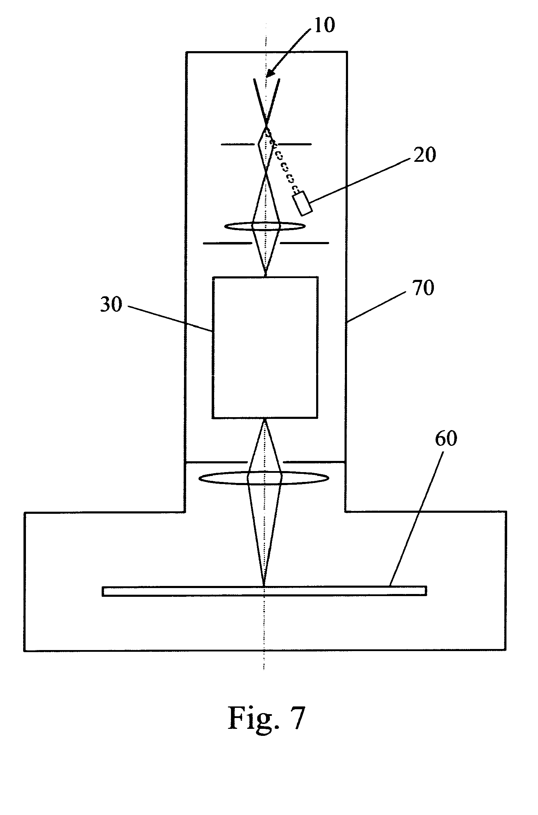

Fig. 7 shows a charged particle apparatus equipped with an emitter arrangement according to an embodiment of the present invention. Therein, the field emission gun 10, 12, the light source 20, the energy filter 30 and a specimen 60 to be inspected are disposed within a vacuum-tight column 70. The field emission gun 10, 12 generates an electron beam which is focused onto the specimen 60 by electron optical lenses. During operation of the field emission gun, the light source 20 illuminates the emitting surface of the emitter tip so that adsorbed atoms and/or molecules desorb therefrom. Thus, continuous cleansing of the emitting surface and, accordingly, continuous stable emission of the field emitter are provided.

Having thus described the invention in detail, it should be apparent for a person skilled in the art that various modifications can be made in the present invention without departing from the spirit and scope of the following claims. For example, it should be understood that the observance of an upper temperature limit is accomplished for every cold cathode emitter.

## Claims

1. A field emitter arrangement (100, 200, 300, 400, 500, 600), comprising:
a field emitter tip (10) having an emitting surface (11), and
at least one light source (20) adapted to illuminate the emitting surface (11) of the field emitter tip (10).

2. The field emitter arrangement (300, 400, 500, 600) according to claim 1,
wherein the light source (20) is a laser.

3. The field emitter arrangement (100, 200, 300, 400, 500, 600) according to claim 1 or 2, wherein the light source (20) is a source of UV light.

4. The field emitter arrangement (300, 400, 500, 600) according to claim 2 or 3, wherein the light source (20) is an UV laser.

5. The field emitter arrangement (400, 500, 600) according to any of the preceding claims, wherein the light source (20) is adapted for pulsed illumination of the emitting surface (11).

6. The field emitter arrangement (500) according to claim 5, further comprising means (23) for synchronizing the light pulses of the light source (20) with a blanking means (40) so that the emitting surface (11) is illuminated only when the electron beam (15) is blanked.

7. The field emitter arrangement (200) according to any of the preceding claims, further comprising means (21) for focusing the light (25) emitted by the light source (20) onto the emitting surface (11).

8. The field emitter arrangement (200) according to any of the preceding claims, further comprising an energy filter (30) for removing photo-emitted electrons from an electron beam (15) generated by the field emitter tip (10).

9. The field emitter arrangement (100, 200, 300, 400, 500, 600) according to any of the preceding claims, wherein the light source (20) is adjusted so that the optical power illuminated onto the emitting surface (11) does not raise the temperature of the emitter tip (10) above 1500°K.

10. The field emitter arrangement (100, 200, 300, 400, 500, 600) according to any of the preceding claims, wherein the field emitter tip (10) is a field emitter tip of a field emitter array.

11. The field emitter arrangement (100, 200, 300, 400, 500, 600) according to claim 10, wherein the light source (20) is adapted to illuminate at least two field emitter tips (10) of the field emitter array simultaneously.

12. A charged particle beam apparatus comprising a field emitter arrangement according to any of claims 1 to 11.

13. A method of cleaning an emitting surface of a field emitter tip, comprising the steps of:
(a) providing a field emitter tip having an emitting surface and a light source (1000),
(b) illuminating the emitting surface of the field emitter tip with the light source (1100).

14. The method according to claim 13, wherein the emitting surface of the emitter tip is continuously illuminated by the light source.

15. The method according to claim 13, wherein the emitting surface of the emitter tip is illuminated in a pulsed manner.

16. The method according to claim 15, wherein emitting surface is illuminated only when an electron beam generated by said field emission tip is blanked (1020).

17. The method according to any of claims 13 to 16, wherein the light source emits an optical power that does not heat the emitter tip to a temperature above 1500°K.

18. The method according to any of the claims 13 to 17, further comprising the step of removing photo-emitted electrons from an electron beam generated by the field emitter tip.
